# EUROPEAN PATENT SPECIFICATION

(11) **EP 3 390 688 B1**
(45) Date of publication and mention of the grant of the patent: **04.01.2023**
(21) Application number: 16876262.3
(22) Date of filing: 08.11.2016
(51) Int. Cl.: H05H 1/48

(54) **HOLLOW CATHODE ION SOURCE AND METHOD OF EXTRACTING AND ACCELERATING IONS**
HOHLKATHODENIONENQUELLE UND VERFAHREN ZUR EXTRAKTION UND BESCHLEUNIGUNG VON IONEN
SOURCE CATHODIQUE CREUSE D'IONS ET PROCÉDÉ D'EXTRACTION ET D'ACCÉLÉRATION D'IONS

(30) Priority: 18.12.2015 US 201514975286; 18.12.2015 US 201514975415
(43) Date of publication of application: 24.10.2018
(73) Proprietor: AGC Flat Glass North America, Inc., Alpharetta, GA 30022 (US); Asahi Glass Co., Ltd., Chiyoda-ku Tokyo 100-8405 (JP); AGC Glass Europe SA, 1348 Ottignies-Louvain-la-Neuve (BE)
(72) Inventor: CHAMBERS, John, Petaluma, California 94954 (US); MASCHWITZ, Peter, Sebastopol, California 95472 (US)
(74) Representative: Hoffmann Eitle
(86) International application number: PCT/US2016/060979
(87) International publication number: WO 2017/105673

(56) References cited:
- US-A- 2 920 235
- US-A- 4 419 203
- US-A- 5 581 155
- US-A1- 2006 030 134
- US-A1- 2006 177 599
- US-A1- 2010 028 238
- US-A1- 2010 028 238
- US-A1- 2010 044 579
- US-A1- 2011 226 611
- US-A1- 2014 099 451
- US-A1- 2014 354 149
- US-B1- 6 174 450

## Description

### BACKGROUND OF THE INVENTION

Ion sources are commonly used for a variety of applications, including substrate treatment in the form of heating, cleaning, surface etching, and chemically modifying a surface. Ion sources can be used for depositing oxides, diamond-like carbon, and other useful coatings. Ion sources can be used to support vacuum deposition processes and to modify thin film growth. For example, ion sources can be used to densify, crystalize, or chemically react with depositing atoms. Virtually all ion sources are designed to operate in the reduced pressure of a vacuum chamber. Some ion sources can be used as low-thrust, long-running engines for spacecraft acceleration.

In their most basic form, ion sources typically consist of a plasma-forming component with additional components to extract and accelerate ions from that plasma. These additional components typically create electric or magnetic fields within the plasma gas other than fields created by the plasma-forming component. These additional fields exert attraction or repulsion forces on ions and result in acceleration of ions. The additional components also add complexity to the overall ion source.

The majority of ions in plasmas are positively charged. That is, they are ionized atoms or molecules, typically missing one or two electrons. When these ions are accelerated out of a plasma, the resulting ion beam often carries a greater number of positively charged particles than negative particles (e.g., electrons). This electrical imbalance can create problems with vacuum hardware or processes. To correct these situations, often an additional electron source device such as a hot filament thermionic electron emitter or hollow cathode electron source is added to inject charge balancing electrons into the ion beam. These electron sources are commonly referred to as neutralizers. As with the other additional components, the use of a neutralizer adds complexity to the overall ion source.

One example of a plasma-forming component used in ion sources is a hollow cathode. Hollow cathodes include linear hollow cathodes and point hollow cathodes. Linear hollow cathodes are not commonly used in ion sources; point hollow cathodes are occasionally used in an ion source being employed as a thruster (*e.g.* for spacecraft acceleration), but such point plasma sources are not usually used for coating substrates (*e.g.*, such as for PECVD coating processes). When hollow cathodes are used, similarly to most ion sources, the extraction of ions from hollow cathode plasmas requires attaching additional components such as separately powered electrodes and magnets. These components often add significant degrees of mechanical and process complexity to an ion source. Further, when using a hollow cathode as the plasma-forming component, known ion sources rely on a dedicated anode structure or separate anodic orifice, resulting in further complexity. Another problem with ion sources is that during dielectric deposition processes, a dielectric coating can build up on the anode structure. Additionally, when ion sources are used in plasma-enhanced chemical vapor deposition (PECVD) processes, the PECVD processes are known for contaminating nearby vacuum chamber hardware including cathode or anode surfaces (for example, contamination may occur from precursor gasses used in these processes reacting with cathode or anode surfaces).
Accordingly, there is a need for an ion source that overcomes these and other disadvantages of known ion sources.

US 2014/0354149A1 discloses an apparatus for generating a hollow cathode arc discharge plasma, including two plasma sources, each including a hollow cathode and an electrode which is associated with the hollow cathode and which has an opening that extends through the electrode, wherein the hollow cathodes of the two plasma sources are connected to a pulse generator which generates a bipolar, medium-frequency pulsed voltage between the two hollow cathodes. In each of the two plasma sources, the hollow cathode is connected in an electrically conducting manner, directly or with interconnection of at least one current direction limiting component, to the associated electrode.

US 2006/0177599A1 discloses a pair of plasma beam sources which are connected across an AC power supply to alternatively produce an ion beam for depositing material on a substrate transported past the ion beams. Each plasma beam source includes a discharge cavity having a first width and a nozzle extending outwardly therefrom to emit the ion beam. The aperture or outlet of the nozzle has a second width, which second width is less than the first width. An ionizable gas is introduced to the discharge cavity. At least one electrode connected to the AC power supply, alternatively serving as an anode or a cathode, is capable of supporting at least one magnetron discharge region within the discharge cavity when serving as a cathode electrode. A plurality of magnets generally facing one another, are disposed adjacent each discharge cavity to create a magnetic field null region within the discharge cavity.

US 2010/0028238A1 discloses linear and two-dimensional plasma sources that produce linear and two dimensional plasmas, respectively, that are useful for plasma-enhanced chemical vapor deposition. The authors further disclose methods of making thin film coatings and methods of increasing the coating efficiencies of such methods.

### BRIEF SUMMARY OF THE INVENTION

The following commonly-assigned applications describe various hollow cathode plasma sources, such as may be used in embodiments of the present invention: U.S. Application No. 12/535,447, now U.S. Patent No. 8,652,586; U.S. Application No. 14/148,612; U.S. Application No. 14/148,606; U.S. Application No. 14/486,726; U.S. Application No. 14/486,779; PCT/US14/068919; and PCT/US14/68858. Additionally, commonly-assigned U.S. Application No. 14/942,737, filed on November 16, 2015, entitled "Plasma Device Driven by Multiple-Phase Alternating or Pulsed Electrical Current," and U.S. Application No. 14/942,673, filed on November 16, 2015, entitled "Method of Producing Plasma by Multiple-Phase Alternating or Pulsed Electrical Current" are also relevant prior art.

Embodiments of the present invention comprise hollow-cathode-based ion sources of surprising simplicity. Embodiments of the present invention can create an energetic ion beam without requiring any additional electrodes, accelerating grids, magnetic fields, neutralizers, or other additional components to extract and accelerate ions. Embodiments of the present invention can also protect cathode and anode surfaces from contamination.

Accordingly, a first aspect of the present invention provides an ion source according to claim 1.

Moreover, a second aspect of the present invention provides a method for extracting and accelerate ions with the ion source of the first aspect of the invention.

Preferred embodiments of the present invention are defined in the dependent claims.

In some embodiments (according to any of the aspects of the invention), the extracted and accelerated ions from at least one of the first ion acceleration cavity and the second ion acceleration cavity form one of: a single narrow beam, a single large-area beam, an array of single beams, and a continuous linear beam curtain. In some embodiments, the extracted and accelerated ions from at least one of the first ion acceleration cavity and the second ion acceleration cavity form a collimated ion beam.

In some embodiments, the first hollow cathode and the first ion accelerator are at a first same electric potential difference and the second hollow cathode and the second ion accelerator are at a second same electric potential difference. In some embodiments, the first hollow cathode and the first ion accelerator are at a first same polarity relative to an electric potential of the plasma and the second hollow cathode and the second ion accelerator are at a second same polarity relative to the electric potential of the plasma.

In accordance with the present invention, the first ion accelerator comprises a portion of the first hollow cathode and/or the second ion accelerator comprises a portion of the second hollow cathode. In some embodiments, the first ion acceleration cavity comprises a slot in the first ion accelerator and/or the second ion acceleration cavity comprises a slot in the second ion accelerator. In some embodiments, the first ion accelerator and the first hollow cathode are electrically insulated from each other and/or the second ion accelerator and the second hollow cathode are electrically insulated from each other. In some embodiments, at least one of the electric potential of the first ion accelerator and the electric potential of the second ion accelerator is switching at a frequency between negative and positive with respect to the electric potential of the plasma. In some embodiments, the first ion accelerator is electrically connected to an exterior of the first hollow cathode and/or the second ion accelerator is electrically connected to an exterior of the second hollow cathode. In some embodiments, the first ion accelerator is electrically connected to an interior of the first hollow cathode and/or the second ion accelerator is electrically connected to an interior of the second hollow cathode.

In some embodiments, at least one of the first ion acceleration cavity and the second ion acceleration cavity is in the form of one of a counterbore, a rectangular slot, a semicircle, a cone, an inverted cone, and a bell shape.

In some embodiments, the interior surfaces of at least one of the first ion accelerator and the second ion accelerator are electron-emitting and electron-accepting. In some embodiments, external surfaces of at least one of the first hollow cathode, the first ion accelerator, the second hollow cathode, and the second ion accelerator are electrically insulated. In some embodiments, the external surfaces are electrically insulated by at least one of a polymer and a non-conductive ceramic. In some embodiments, the external surfaces are electrically insulated by a dark space shield.

In some embodiments, the chamber comprises a vacuum chamber. In some embodiments, the first plasma exit orifice restricts gas flow between the first hollow cathode and the chamber and/or the second plasma exit orifice restricts gas flow between the second hollow cathode and the chamber. In some embodiments, at least one of the first ion acceleration cavity and the second ion acceleration cavity comprises an elongated cavity. In some embodiments, at least one of the first plasma exit orifice and the second plasma exit orifice comprises a plasma exit nozzle. In some embodiments, at least one of the first plasma exit orifice and the second plasma exit orifice comprises a plurality of plasma exit nozzles. In some embodiments, at least one of the first plasma exit orifice and the second plasma exit orifice comprises a linear slot.

In some embodiments, the first ion acceleration cavity partially encloses gas emerging from the first plasma exit orifice and/or the second ion acceleration cavity partially encloses gas emerging from the second plasma exit orifice. In some embodiments, an average energy of the extracted and accelerated ions is less than 100eV. In some embodiments, an average energy of the extracted and accelerated ions is greater than 100eV.

In some embodiments, the ion source further includes a source of power configured to power at least one of the first hollow cathode, the first ion accelerator, the second hollow cathode, and the second ion accelerator.

In some embodiments, the source of power operates at a root-mean-square AC voltage between 200V and 1000V. In some embodiments, the source of power operates at a root-mean-square AC voltage between 20V and 200V.

In some embodiments, the first and second hollow cathodes are configured such that, the hollow cathode serving as positive electrode is more positively biased than walls of the chamber. In some embodiments, the first and second ion accelerators are configured such that the first and second ion accelerators are biased more positively than the corresponding first and second hollow cathodes during the positive portion of the cycle for the respective ion accelerator and hollow cathode. In some embodiments, the first and second ion accelerators are configured such that the first and second ion accelerators are biased less positively than the corresponding first and second hollow cathodes during the positive portion of the cycle for the respective ion accelerator and hollow cathode. In some embodiments, the only electrically active surfaces consist essentially of an inner wall of each of the first and second hollow cathodes and an inner wall of each of the first and second ion accelerators. In some embodiments, the frequency that the first hollow cathode and the second hollow cathode alternate between electrode and counter-electrode is from about 1kHz to about 1MHz.

In some embodiments, at least one of the first ion acceleration cavity and the second ion acceleration cavity is angled to distribute ion bombardment to a common line. In some embodiments, the plasma is self-neutralizing. In some embodiments, the ion source is absent of any Hall current. In some embodiments, the ion source is absent of any accelerating grids. In some embodiments, the ion source is from about 0.1m to about 4m long and has uniform plasma and ion emission over the length of the ion source.

In some embodiments, the first ion acceleration cavity and the second ion acceleration cavity are sufficient to enable the extraction and acceleration of ions without the use of additional components to extract and accelerate ions from that plasma.

### BRIEF DESCRIPTION OF THE SEVERAL VIEWS OF THE DRAWINGS

The accompanying drawings, which are incorporated herein and form part of the specification, illustrate various embodiments of the present disclosure and, together with the description, further serve to explain the principles of the disclosure and to enable a person skilled in the pertinent art to make and use the embodiments disclosed herein. In the drawings, like reference numbers indicate identical or functionally similar elements.
FIG. 1A illustrates a known hollow cathode plasma source with an array of nozzles as a plasma exit region.
FIG. 1B illustrates a known hollow cathode plasma source with a linear slot as a plasma exit region.
FIG. 1C illustrates a known hollow cathode plasma source with a single hole as plasma exit region.
FIG. 2A illustrates a hollow cathode ion source with an array of nozzles as a plasma exit region according to exemplary embodiments of the present invention.
FIG. 2B illustrates a hollow cathode ion source with a linear slot as a plasma exit region according to exemplary embodiments of the present invention.
FIG. 2C illustrates a hollow cathode ion source with a single hole as a plasma exit region according to exemplary embodiments of the present invention.
FIG. 3A illustrates an alternative ion acceleration cavity shape according to exemplary embodiments of the present invention.
FIG. 3B illustrates an alternative ion acceleration cavity shape according to exemplary embodiments of the present invention.
FIG. 3C illustrates an alternative ion acceleration cavity shape according to exemplary embodiments of the present invention.
FIG. 3D illustrates an alternative ion acceleration cavity shape according to exemplary embodiments of the present invention.
FIG. 4A illustrates an ion accelerating unit having an ion acceleration cavity formed in the hollow cathode body according to exemplary embodiments of the present invention.
FIG. 4B illustrates an ion accelerating unit having an ion acceleration cavity electrically separated from the hollow cathode body according to exemplary embodiments of the present invention.
FIG. 5 illustrates a method of extracting and accelerating ions according to exemplary embodiments of the present invention.
FIG. 6 illustrates a coating-substrate combination according to exemplary embodiments of the present invention.
FIG. 7 is a photograph showing an ion source after 24 hours of runtime according to exemplary embodiments of the present invention.
FIG. 8 is a photograph showing an ion etched pattern on a glass substrate according to exemplary embodiments of the present invention.
FIG. 9A is a photograph showing plasma being formed by a known hollow cathode plasma source.
FIG. 9B is a photograph showing plasma being formed by an ion source according to exemplary embodiments of the present invention.

### DETAILED DESCRIPTION OF THE INVENTION

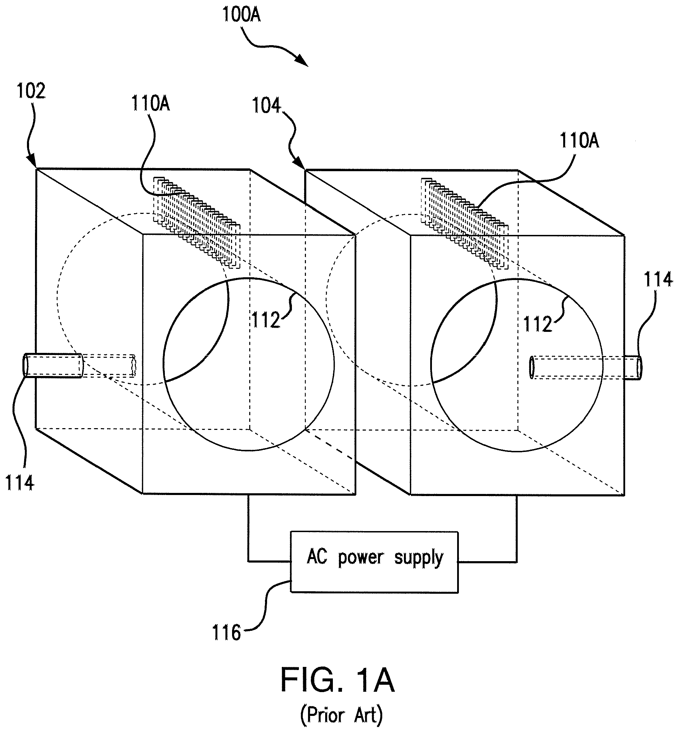

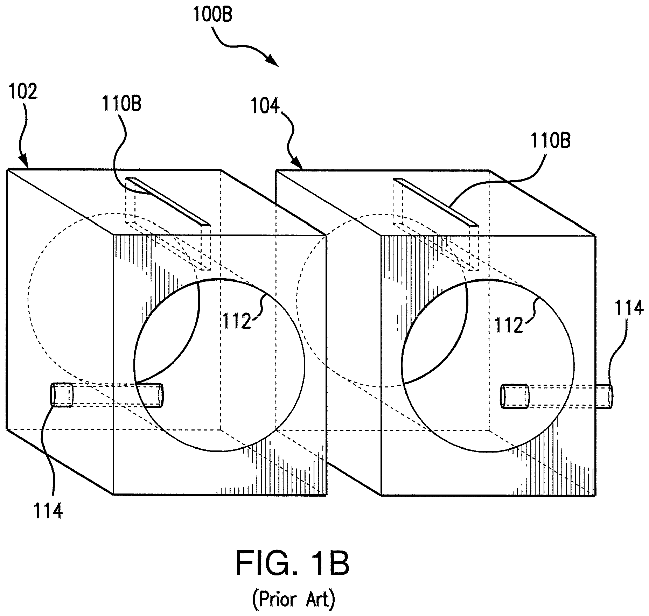

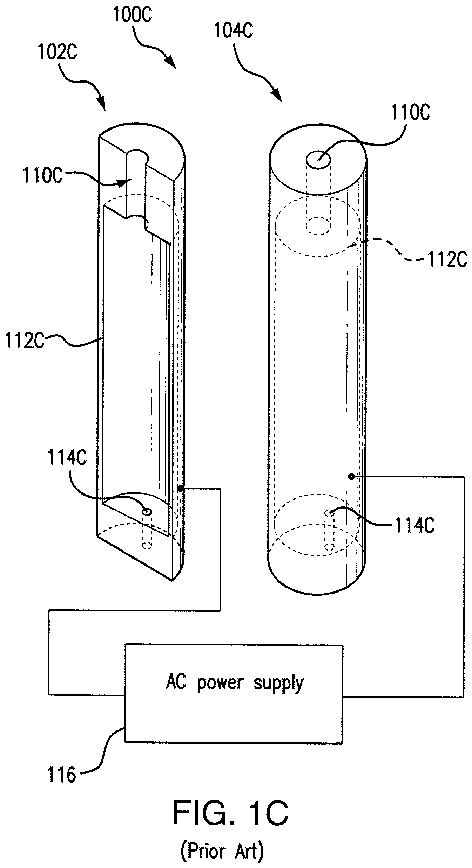

FIGs. 1A, 1B, and 1C, illustrate known hollow cathode plasma sources 100A, 100B, 100C. As shown in FIG. 1A, hollow cathode plasma source 100A includes a first linear hollow cathode 102 and a second linear hollow cathode 104, each connected to power source 116. Each linear hollow cathode 102, 104 includes an interior hollow cathode cavity 112 and a gas inlet 114 to allow plasma-forming gasses to enter into the hollow cathode cavity 112. Additionally, the hollow cathodes 102, 104 include a plasma exit region. As shown in FIG. 1A, the plasma exit region consists of an array of holes or nozzles 110A leading from the hollow cathode cavity 112 to the process chamber that houses the hollow cathodes. As shown in FIG. 1B, the plasma exit region consists of a single slot 110B in the hollow cathode body. FIG. 1C shows a tubular or cylindrical point hollow cathode plasma source, including tubular hollow cathodes 102C, 104C each having a hollow cathode cavity 112C and a gas inlet 114C, analogous to the cavity and gas inlet of FIGs. 1A and 1B for a linear hollow cathode plasma source. As shown in FIG. 1C, the plasma exit region consists of a single hole 110C. The plasma source shown in FIG. 1C is a point source which results in an approximately 0-dimensional "point" of plasma, whereas the linear plasma sources of FIGs. 1A and 1B result in an approximately 1-dimensional "line" of plasma. One of skill in the art will recognize that the resulting plasma is not mathematically 0-dimensional or 1-dimensional, and that these terms are merely approximations for describing the plasma being generated by the plasma sources.

Power source 116 is electrically connected to each hollow cathode and comprises an alternating-current power source. The power source 116 causes the two hollow cathodes to have opposite polarity relative to each other. As this polarity switches, each hollow cathode will alternatively serve as cathode and anode. As is well known in the art, and as disclosed in previous applications by the present inventors (such as, for example, the applications incorporated by reference above), a bipolar power supply initially drives a first electron emitting surface to a negative voltage, allowing plasma formation, while the second electron emitting surface is driven to a positive voltage in order to serve as an anode for the voltage application circuit. This then drives the first electron emitting surface to a positive voltage and reverses the roles of cathode and anode. As one of the electron emitting surfaces is driven negative, a discharge forms within the corresponding cavity. The other cathode then forms an anode, causing electron current to flow from the cathodic hollow cathode to the anodic hollow cathode.

Note that in the figures, the hollow cathode cavities are shown as unenclosed, or open, solely for purposes of illustration. In practice, the hollow cathode cavity is surrounded by the hollow cathode body, and the only openings are from the gas inlet and the plasma exit region.

The linear hollow cathode plasma sources 100A and 100B illustrated in FIGs. 1A and 1B, respectively, are not usually used in ion sources. The point hollow cathode plasma source illustrated in FIG. 1C is occasionally used in an ion source being employed as a thruster (e.g. for spacecraft acceleration), but such point plasma sources are not usually used for coating substrates (e.g., such as for PECVD coating processes).

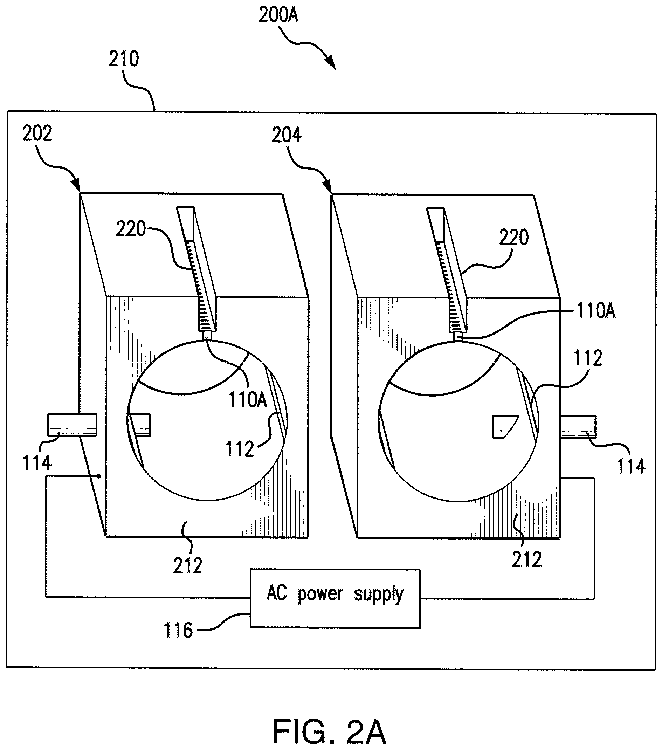

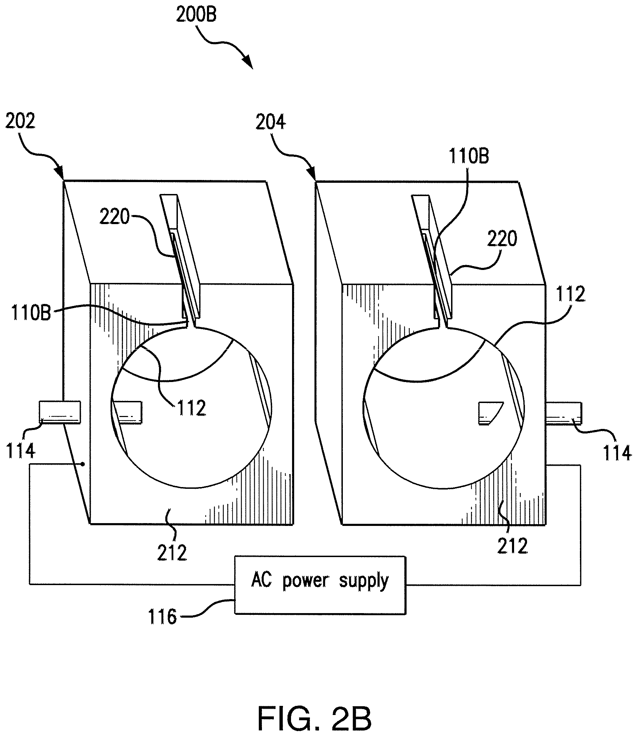

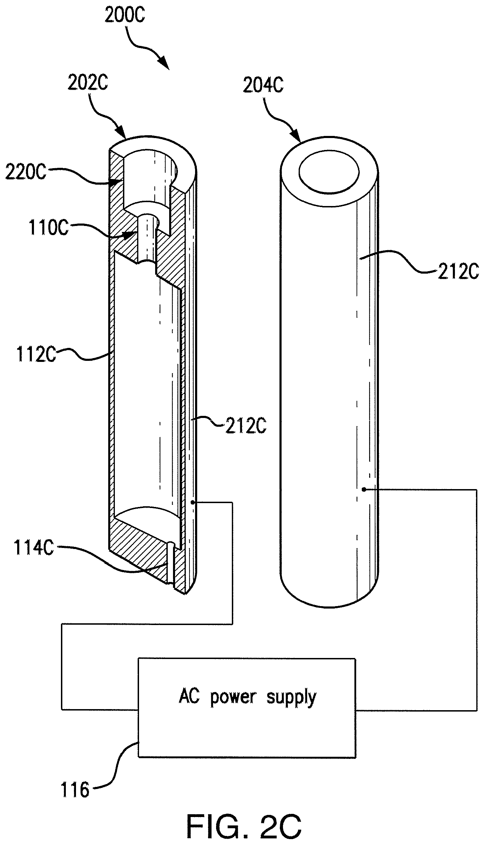

FIGs. 2A, 2B, and 2C, illustrate hollow cathode ion sources 200A, 200B, and 200C, respectively, according to exemplary embodiments of the present invention. As shown in FIG. 2A, hollow cathode ion source 200A includes a first ion accelerating unit 202 and a second ion accelerating unit 204, each connected to power source 116. Each ion accelerating unit 202, 204 includes a hollow cathode body 212, an interior hollow cathode cavity 112, and a gas inlet 114 to allow plasma-forming gasses to enter into the hollow cathode cavity 112. Additionally, the ion accelerating units 202, 204 include a plasma exit region. As shown in FIG. 2A, the plasma exit region consists of an array of holes (or nozzles) 110A leading from the hollow cathode cavity 112. Whereas in hollow cathode plasma source 100A, the plasma exit region led from the hollow cathode cavity to the process chamber that houses the hollow cathodes; in the ion source 200A, the plasma exit region consisting of an array of holes 110A leads from the hollow cathode cavity 112 to an ion acceleration cavity 220. As shown in FIG. 2B, the plasma exit region consists of a single slot 110B in the hollow cathode body leading to an ion acceleration cavity 220. FIG. 2C shows ion accelerating units 202C, 204C each having a tubular hollow cathode body 212C, a hollow cathode cavity 112C, and a gas inlet 114C. As shown in FIG. 2C, the plasma exit region consists of a single hole 110C leading to an ion acceleration cavity 220C.

Referring now to FIG. 2A, hollow cathode ion source 200A includes a chamber 210 which houses the ion accelerating units 202, 204. In some embodiments, chamber 210 is a vacuum chamber.

As the voltage or polarity of the hollow cathodes changes, relative to the plasma potential, this creates an electric repulsive force that will accelerate ions. During the positive pulse, positive ions are repulsed and accelerated from the cavity. During the negative pulse, negative ions are accelerated. Plasma activated oxygen is known to produce negative ions which make embodiments of this ion source useful for accelerating ion beams of inert or oxygen reactive gas, due to the alternating function of each hollow cathode as anode and cathode. Rather than requiring additional components and separate electric or magnetic fields, in the present invention, the hollow cathode plasma source itself, in combination with the ion acceleration cavity, creates the necessary repulsive force to extract and accelerate ions. Additionally, most existing ion sources do not work well with oxygen, as components of existing ion sources can have disadvantageous reactions with oxygen.

Although plasma is a gas phase material, it is highly electrically conductive. Due to this conductivity, plasma may carry a charge or electrical voltage bias. The plasma formed by the hollow cathodes of embodiments of this invention are non-equilibrium, non-thermal plasmas which typically carry a charge of from ground potential to a few tens of volts (typically no more than 30V) positive.

The hollow cathode body and ion acceleration cavity should also be functionally at the same electrical potential or at least the same polarity relative to the plasma potential. Thus, the first ion accelerating unit's hollow cathode body and the corresponding ion acceleration cavity should be at a first same potential or polarity and the second ion accelerating unit's hollow cathode body and the corresponding ion acceleration cavity should be at a second same potential or polarity. Part of the simplicity of embodiments of the present invention is that no additional power supplies or electrodes of separate polarity are needed to accelerate ions. In some embodiments, both the hollow cathode cavity walls and the ion acceleration cavity walls are electrically connected to one power supply.

As the hollow cathode bodies and ion acceleration cavities alternate from negative to positive polarity, they alternatively switch between serving as electron emitters and electron collectors. An electron current is established between the hollow cathodes. It is advantageous to restrict the electron emitting and collecting surfaces to specific areas of the device. While not necessary, the ion source of the disclosed embodiments functions optimally when electron emission and collection occurs on the hollow cathode plasma cavity walls, the ion acceleration cavity walls, and the plasma exit orifice walls, and when the orifices are conductive.

According to some embodiments, an average energy, or alternatively a median energy, of the extracted and accelerated ions is greater than 100eV. In other embodiments, the average or median energy is less than 100eV. For example, using a "cold" hollow cathode plasma source, which operates at approximately 500V, the ion source is capable of etching which indicates ion energies in excess of 100eV, and as high as 1500eV. Using a "hot" hollow cathode plasma source, the ion beam does not have sufficient energy to etch, which indicates ion energies less than 100eV, and on the order of 10eV. This capability to produce widely varying ion energies is advantageous. In particular, ion sources with energies on the order of 10eV are difficult to design using conventional ion source technology. This is especially true regarding linear ion sources.

It will be appreciated that each of ion accelerating units 202, 202C, 204, 204C is capable of forming an ion beam by extracting and accelerating ions. Accordingly, in some embodiments, there will be at least two distinct ion beams formed from the ion source.

As will be appreciated by one of skill in the art by the present disclosure, power source 116 may be a conventional bipolar (two-phase) power source. Power source 116 may also be a multiphase power source, and may be electrically connected to more than two ion accelerating units. For example, as described in U.S. Application Nos. 14/942,737 and 14/942,673, ion sources 200A, 200B, 200C (or any other ion source enabled by this disclosure) can include at least three ion accelerating units, each including hollow cathode bodies that are electrically powered by at least three phase-offset waves.

Hollow cathodes, according to the exemplary embodiments disclosed herein, must be sufficiently close to each other to allow an electron current to flow between hollow cathodes of opposite polarity. In some embodiments, this proximal distance may be from approximately 5mm to 500mm. As illustrated in FIGs. 2A, 2B and 2C, the hollow cathode bodies 212, 212C are of elongated design. In some embodiments, a length of these hollow cathodes may be from about 50mm to about 10 meters, and in some embodiments the length may be even greater than 10 meters. In some embodiments, the hollow cathode bodies are straight, but the hollow cathode bodies can also be circular or of a convoluted shape. For example, in some embodiments, a circular and concentric arrangement of hollow cathode bodies can result in a single large area ion beam.

One of skill in the art will also appreciate that, while ion accelerating units 202, 202C, 204, 204C are shown as rectangular or tubular, ion accelerating units and the cavities formed within those ion accelerating units, such as the hollow cathode cavities, in accordance with embodiments of this invention, may include other shapes. Hollow cathode cavity widths (or diameters) may be (for example) from about 8mm to about 100mm. In certain embodiments, operating pressure inside the chamber may be from about 0.1 milliTorr (0.013 Pascals) to about 100 milliTorr (13 Pascals), or more typically from about 1.0 milliTorr (0.13 Pascals) to about 50 milliTorr (6.7 Pascals). The general chamber pressure will typically be less than the pressure within the hollow cathode cavity. As will be appreciated, plasma gas pressure within the cavity can be controlled so that cavity width (or diameter) is inversely proportional to plasma gas pressure within the cavity.

The construction materials for a hollow cathode body, including cavity walls, must be sufficiently electrically conductive so that electrons can be emitted from cavity wall surfaces and the walls can carry the necessary electrical current to sustain the discharge. Examples of cavity wall construction materials include metals, metal alloys, metal compounds, carbon, carbon compounds, conductive ceramics, and/or semiconductors. Commonly used materials are metal, metal alloys and/or carbon in the graphitic form. In some cases cavity wall materials may be chosen for desirable electron emission properties. Cavity walls may comprise materials with low work function or high secondary electron emission coefficients which allow lower operating voltages and increased electron current. In some cases these specialized materials may comprise an interior cavity wall coating on a metal or carbon base (for example, a tungsten-carbide coating to reduce sputtering). Embodiments of the present invention are effective with a wide variety of cavity wall materials.

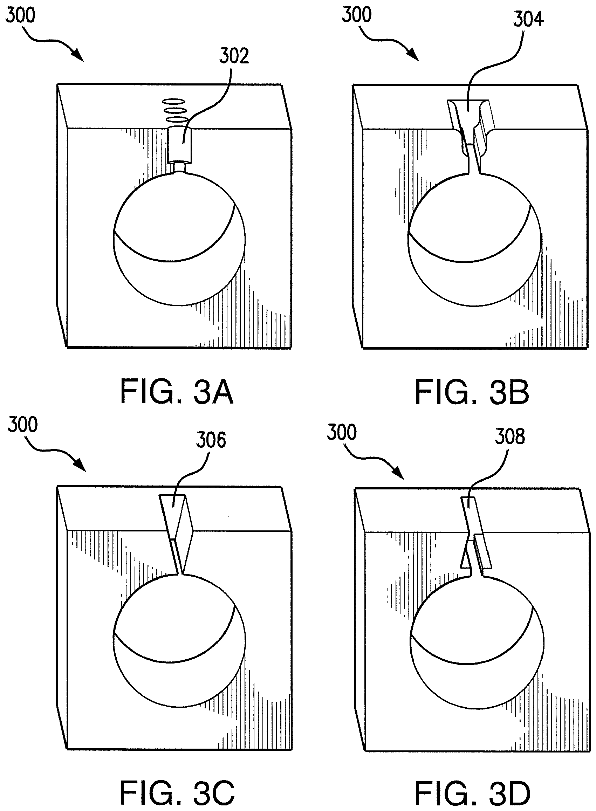

In some embodiments, the hollow cathode cavity is from about 8mm to about 100mm in width or diameter. The plasma exit region may be from about 1mm to about 20mm, or from about 2mm to about 15mm, in width or diameter. The ion acceleration cavity, in accordance with the present invention, is wider (or has a larger diameter) than the plasma exit region. In some embodiments, the ion acceleration cavity has a width or diameter from about 2mm to 25mm, or about 3mm to 20mm. In some embodiments, the ion acceleration cavity may be a rectangular slot (*e.g.,* as depicted in FIGs. 2A and 2B) or a circular slot (*e.g.,* as depicted in FIG. 2C). However, as will be appreciated, other shapes are possible. For example, FIGs. 3A-D illustrate alternative ion acceleration cavity shapes according to exemplary embodiments of the present invention. As shown in FIGs. 3A-D, ion accelerating unit 300 includes an ion acceleration cavity 302, 304, 306, 308. The ion acceleration cavity may include an array of cylindricallyshaped cavities (302) (shown in FIG. 3A), a bell-shaped ion acceleration cavity (304) (shown in FIG. 3B), or a widening (306) (shown in FIG. 3C) or narrowing (308) (shown in FIG. 3D) coneshaped ion acceleration cavity. In some embodiments, the ion acceleration cavity may be in the form of a counterbore, a rectangular slot, a semicircle, a cone, an inverted cone, and a bell shape. As will be appreciated, the shape and configuration of the ion acceleration cavity will affect the ion beam resulting from the ion accelerating unit.

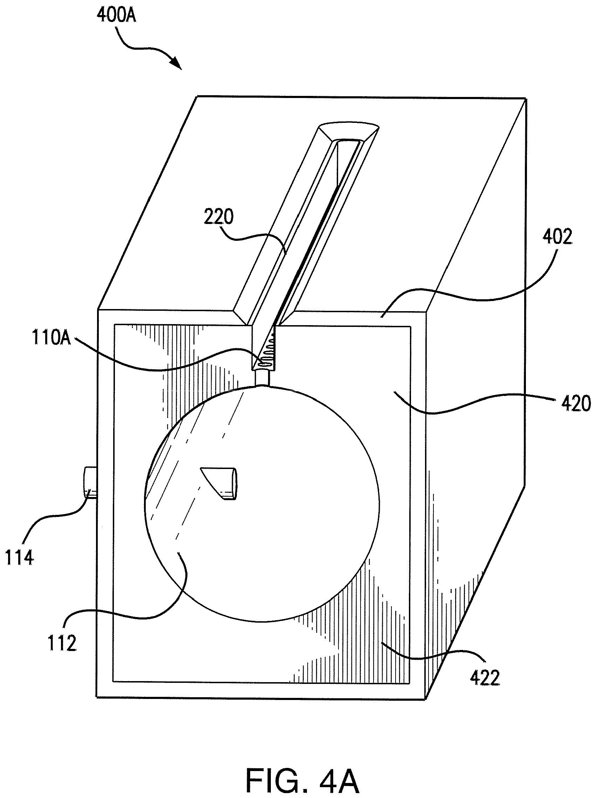

FIG. 4A illustrates an ion accelerating unit 400A according to exemplary embodiments of the present invention. Ion accelerating unit 400A may be used as part of an ion source, such as, for example, ion sources 200A, 200B, 200C. Ion accelerating unit 400A includes a hollow cathode body 422, a gas inlet 114, a hollow cathode cavity 112, a plasma exit region 110A, and an ion acceleration cavity 220. Ion accelerating unit 400A further includes an electrically insulating shell 402 covering all exterior electrically conductive parts. In some embodiments, the only conductive surfaces exposed to plasma are the interior of the hollow cathode cavity, the plasma exit orifices, and the ion acceleration cavity. The insulating shell 402 may, in some embodiments, include a cover of non-conductive material, such as ceramic, polymer, or other dielectric materials. The insulating shell 402 may also include a dark space shield. As shown in FIG. 4A, the ion accelerator 420, which forms ion acceleration cavity 220, is part of the hollow cathode body 422.

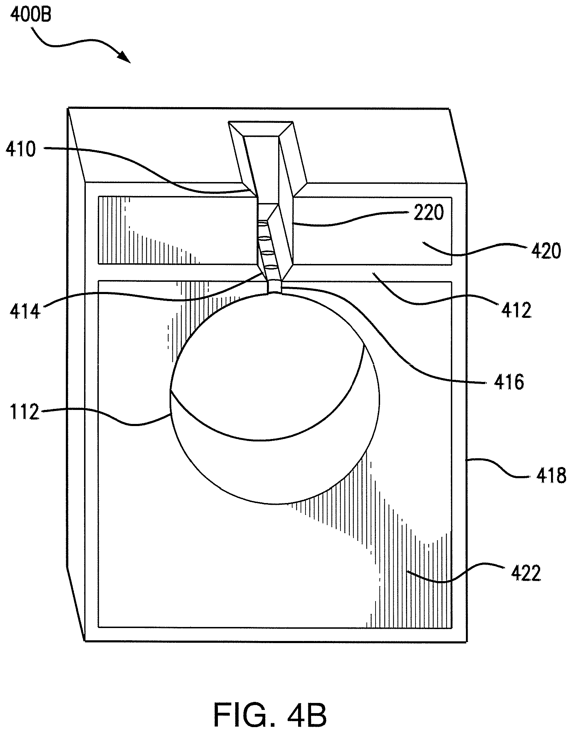

FIG. 4B illustrates an ion accelerating unit 400B according to exemplary embodiments of the present invention. Ion accelerating unit 400B may be used as part of an ion source, such as, for example, ion sources 200A, 200B, 200C. In such ion sources, ion accelerating unit 400B may be used in combination with additional ion accelerating units 400B, with ion accelerating unit 400A, or with other ion accelerating units according to embodiments of the present invention. Ion accelerating unit 400B includes a hollow cathode body 422, a gas inlet (not shown), a cavity 112, a plasma exit region 416, and an ion acceleration cavity 220. In the design illustrated in FIG. 4B, the hollow cathode body and the ion acceleration body are separate components. Insulating wall 418 surrounds the hollow cathode body while insulating walls 410, 412 surround the ion acceleration body. Insulating wall 412 is between the ion acceleration body and the hollow cathode body and includes an opening 414 to allow the plasma exit region to be in communication with the ion acceleration cavity. The insulating material 410, 412, 418 may, in some embodiments, include a cover of non-conductive material, such as ceramic, polymer, or other dielectric materials. The insulating material 410, 412, 418 may also include a dark space shield. As shown in FIG. 4B, the ion accelerator 420, which forms ion acceleration cavity 220, is separated from hollow cathode body 422 by insulating shell 412.

As is known in the art, a dark space shield refers to a region around the plasma source having a narrow space (on the order of 5mm or less) where at low pressure it is physically impossible for plasma to form. As is known in the art, the dark space shield is dependent on gas composition, pressure, and voltage.

Referring now to FIGs. 4A and 4B, in accordance with the present invention, the ion acceleration cavity is an integral part of the hollow cathode body or, in embodiments not covered by the claimed invention, is a separate component from the hollow cathode body. For example, in FIG. 4A, the ion acceleration cavity may be cut into the hollow cathode body material as a slot. This will effectively force the ion acceleration body and the hollow cathode body to have the same electrical potential and polarity. As shown in FIG. 4B, the ion acceleration cavity may be electrically insulated from the main hollow cathode body. For example, in FIG. 4B the ion accelerator may be made of a different material than the main hollow cathode body. In this arrangement, according to some embodiments of the present invention, it will be necessary to maintain the electrical polarity relationships between the hollow cathode cavity walls and ion acceleration cavity walls.

In some embodiments, the first and second ion accelerators are configured such that the first and second ion accelerators are biased more positively (or less positively) than the corresponding first and second hollow cathode bodies during the positive portion of the cycle for the respective ion accelerator and hollow cathode body. Specifically when the ion accelerator 420 and the hollow cathode body 422 are electrically insulated (for example, as shown in FIG. 4B), each ion accelerator can be configured to be biased more positively (or less positively) than the corresponding hollow cathode body while that corresponding hollow cathode body is functioning as an anode (*i.e.,* during the positive portion of the cycle). This can be done while still maintaining the necessary electrical polarity relationships between the hollow cathode body and ion accelerator. By managing the relative voltage between the ion accelerator and the hollow cathode body in this way, the resulting acceleration of the ions can be controlled.

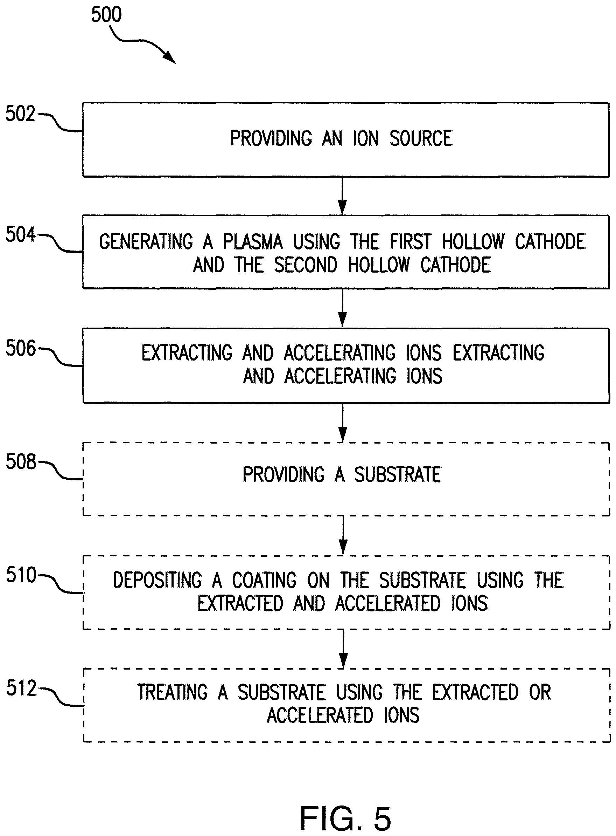

FIG. 5 illustrates a method according to exemplary embodiments of the present invention. Method 500 includes providing an ion source, for example ion source 200A (step 502). The ion source 200A includes a chamber 210. In some embodiments, the chamber 210 is a vacuum chamber. The ion source 200A further includes a first ion accelerating unit 202 having a first hollow cathode body 212, a first hollow cathode cavity 112, and a first plasma exit orifice 110A and a second ion accelerating unit 204 having a second hollow cathode body 212, a second hollow cathode cavity 112, and a second plasma exit orifice 110A, the first and second hollow cathode bodies being disposed adjacently in the chamber 210. The ion source 200A further includes a first ion accelerator (such as element 420 in FIG. 4) between and in communication with the first plasma exit orifice 110A and the chamber 210. The first ion accelerator 420 forms a first ion acceleration cavity 220. The ion source 200A further includes a second ion accelerator (such as element 420 in FIG. 4) between and in communication with the second plasma exit orifice 110A and the chamber 210. The second ion accelerator 420 forms a second ion acceleration cavity 220. The first hollow cathode body and the second hollow cathode body alternatively function as electrode and counter-electrode (e.g., alternatively function as cathode and anode) to generate a plasma. Each of the first elongated ion acceleration cavity and the second elongated ion acceleration cavity are sufficient to enable the extraction and acceleration of ions without requiring any additional electrodes, accelerating grids, magnetic fields, neutralizers, or other additional components. Method 500 further includes generating a plasma using the first hollow cathode body and the second hollow cathode body (step 504). Method 500 further includes extracting and accelerating ions (step 506). Optionally, method 500 may include providing a substrate (step 508) and depositing a coating on the substrate using the extracted and accelerated ions (step 510) or treating the substrate using the extracted and accelerated ions (step 512). As will be appreciated, in accordance with the invention, the extracted and accelerated ions are extracted and accelerated away from the ion acceleration cavity. In some embodiments, the extracted and accelerated ions are further extracted and accelerated toward the substrate.

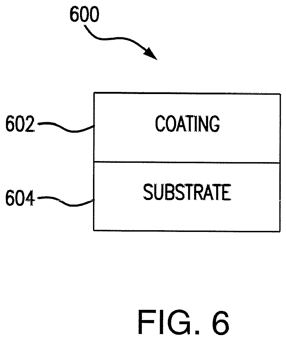

FIG. 6 illustrates a coating-substrate combination 600, including a coating 602 and a substrate 604. An ion source according to embodiments of the present invention may be used to deposit coating 602 on substrate 604, or alternatively, to treat an already-deposited coating 602. For example, an ion source according to embodiments of the present invention can be used to treat or etch glass substrates, deposit coatings, or densify coatings.

One factor influencing electron current is the temperature of hollow cathode cavity walls. In a hollow cathode setup with cavity wall temperature below about 1000°C, electron emission is dominated by secondary electron emission. Although thermionic emission may be present for temperatures above about 750°C, secondary electron emission still dominates until about 1000°C. As cavity walls are bombarded by ions, the impacting ion kinetic energy along with a negative voltage potential induces electrons to be emitted from wall surfaces. Typically, these "cold" hollow cathodes are run with cavity wall temperatures from about 50°C to about 500°C. Generally, to maintain hollow cathode structures at these temperatures, cooling methods are applied. Often, water cooling channels are built into the hollow cathode structure. Operating voltage for cold hollow cathode discharges is typically from about 300 volts to about 1000 volts.

Alternatively, hollow cathodes may be run in thermionic mode. For thermionic electron emission to occur, hollow cathode cavity wall temperatures usually range from about 750°C to about 2000°C. Thermionic hollow cathodes may incorporate heaters around cavity walls to help raise temperature or, more simply, may rely on plasma energy transfer to heat cavity walls. Generally, hot cavities are thermally insulated to reduce conductive or radiative heat loss. Operating voltage for thermionic hollow cathode discharges is typically from about 10 volts to about 300 volts or more commonly from about 10 volts to about100 volts.

Unlike most conventional ion sources, the ion sources of the disclosed embodiments are compatible with either temperature range or any electron emission mode.

In order to facilitate plasma generation inside of a hollow cathode, a plasma forming gas is introduced within the hollow cathode cavity. This gas becomes ionized through collisions with free, oscillating electrons within the hollow cathode cavity. Typically, in enclosed hollow cathode cavities, a plasma gas is introduced to the cavity space through a gas inlet tube or orifice. Nearly any material in gas phase may be used as the plasma forming gas. Most common gases used as plasma forming gases include He, Ne, Ar, Kr, Xe, O₂, N₂, and H₂. Unlike many ion sources which are limited to inert gasses, generally, the ion sources of the disclosed embodiments will form an ion beam from any ionized gas, including inert or non-inert gasses. Some gas limitations may occur with high temperature hollow cathode cavity materials. For example, hollow cathode cavity wall materials above 1000°C may chemically react with some ionized gases such as oxygen. If such reactions result in growth of electrically insulating coatings on cavity walls, electron emission can be inhibited. Another consideration for gas or material selection is erosion, or the burning away, of the hollow cathode cavity.

Typical plasma formation gas flows for the point source embodiments disclosed herein may be from about 1 standard cubic centimeter per minute (or sccm) to about 100 sccm. For the linear embodiments disclosed herein, plasma forming gas flows in some embodiments may be from about 0.5 sccm to about 10 sccm per linear mm of cavity length. More typical linear gas flows may be from about 1 sccm to about 5 sccm per mm. These values refer to the total gas flow, summed over each ion accelerating unit in the chamber. As will be appreciated, the total gas flow may be limited by the ability of the vacuum pump used to maintain pressure in the chamber.

In some embodiments of the present invention, plasma exit orifice walls may comprise the same conductive material as the hollow cathode body or cavity walls, such as metal or carbon. The plasma exit orifice walls may also comprise other hard or heat resistant materials such as tungsten carbide. These plasma exit orifices do not necessarily have to be electrically conductive and may comprise a ceramic dielectric material such as a ceramic insert.

The typical diameter of a plasma exit hole or width of a plasma exit slot may be from about 0.5mm to about 8mm. Most frequently used sizes are from about 1mm to about 6mm. In the case of plasma exit holes, spacing may vary widely from center to center distance of about 1.5mm to about 50mm. Spacing between adjacent holes may be uniform or irregular, according to embodiments of the present invention. As a non-limiting example, a uniform ion beam curtain can be established from an exemplary ion source with spacing between plasma exit holes of about 5mm to about 30mm.

In embodiments of the present invention, the ion beam formed by at least one of the first ion acceleration cavity and the second ion acceleration cavity may be configured to be a single narrow beam, a single large area beam, an array of single beams, or a continuous linear ion beam curtain. In some embodiments, the ion beam may be at least partially collimated. For example, the design of the ion acceleration cavity will affect the type of ion beam that is created. As will be appreciated, each of the first ion acceleration cavity and the second ion acceleration cavity may form an ion beam, and the ion beam formed by each ion acceleration cavity may be configured to be the same or different as the ion beam formed by the other ion acceleration cavity.

As explained above, when conventional ion sources are used in conjunction with PECVD coating processes, these processes are known for contaminating and coating all nearby vacuum chamber hardware including cathode or anode surfaces. However, in embodiments of the present invention, the hollow cathode cavity walls and ion acceleration cavity walls are protected from this contamination problem. For example, both of these two surfaces are at least partially enclosed and isolated from gases external to the hollow cathode. Both of these two surfaces also tend to be kept clean and electrically conductive by the flow of plasma forming gas flowing across them. That is, the plasma gas tends to sweep away potentially contaminating gases such as precursors used in the PECVD process.

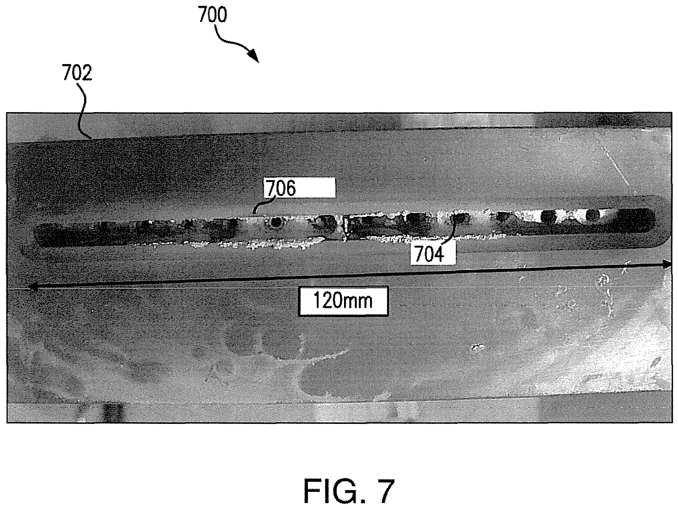

FIG. 7 is a photograph 700 showing an ion source after 24 hours of runtime according to exemplary embodiments of the present invention. Specifically, the ion source includes a hollow cathode 702 having an array of nozzles as a plasma exit region 704 and an ion acceleration cavity 706. The white areas in FIG. 7 are from accumulation of electrically non-conductive titanium dioxide (TiO₂) on the walls of the ion acceleration cavity. This contamination can negatively impact the ion source. As shown, the ion source in FIG. 7 comprises an array of nozzles as the plasma exit region. A dark space shield functioning as an insulating shell is present over the face of the hollow cathode.

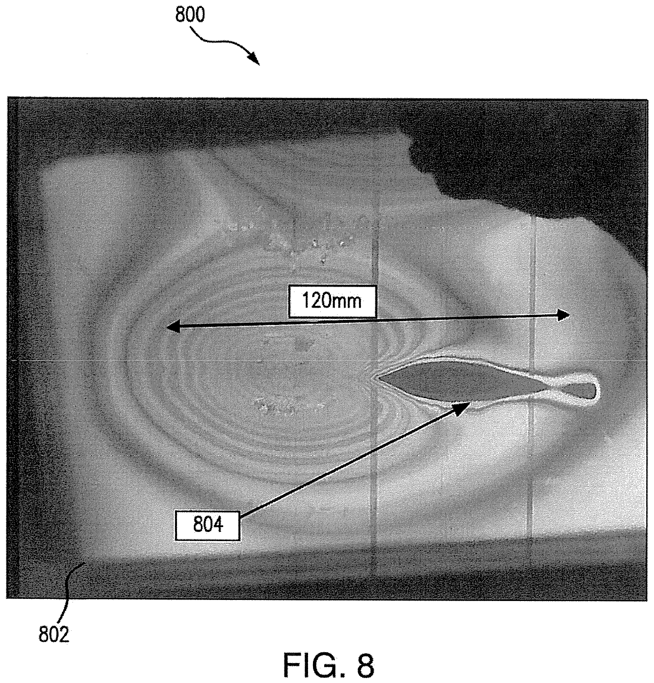

FIG. 8 is a photograph 800 showing an ion etched pattern on a glass substrate 792 according to exemplary embodiments of the present invention. Color fringes are about 0.3µm thick titanium oxide coating on the glass substrate. The etched region 804 is approximately 250µm deep into the glass substrate 802. Plasma and ion beam exposure time on the substrate was approximately 24 hours. During the etching process, no electric charging of the substrate or plasma generation hardware occurred.

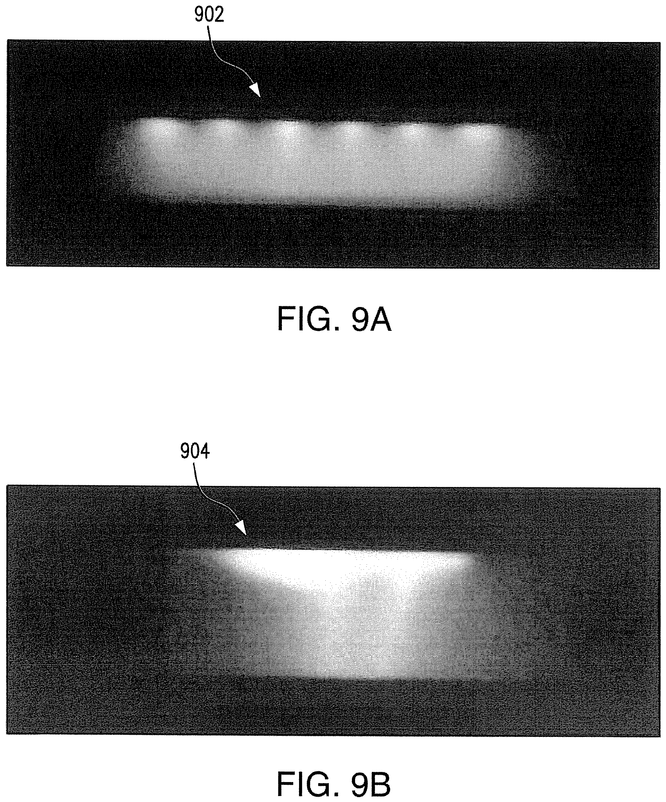

FIG. 9A is a photograph showing plasma 902 being formed by a known hollow cathode plasma source. The hollow cathode plasma source comprised six nozzles as a plasma exit region and did not include an ion acceleration cavity. The plasma source shown in FIG. 9A is similar to that depicted by FIG. 1A.

FIG. 9B is a photograph showing plasma 904 being formed by an ion source according to exemplary embodiments of the present invention. The bipolar hollow cathode ion source here included twelve nozzles as a plasma exit region and an ion acceleration cavity 10mm deep and 4.8mm wide. As can be seen, the lighter streaks in the plasma are indicative of a beam of ions being accelerated from the source down to the substrate.

Many other combinations of hollow cathodes and multiphase power inputs are possible with the specific arrangements being designed to suit a particular application, as one of ordinary skill in the art will appreciate from the present disclosure.

While various embodiments have been described above, it should be understood that they have been presented by way of example only, and not limitation. Thus, the scope of the present invention should not be limited by any of the above-described exemplary embodiments.

Other embodiments are possible without departing from the scope of the present invention. The scope of the present invention is defined by the appended claims.

Additionally, while the processes described above and illustrated in the drawings are shown as a sequence of steps, this was done solely for the sake of illustration. Accordingly, it is contemplated that some steps may be added, some steps may be omitted, the order of the steps may be re-arranged, and some steps may be performed in parallel without departing from the scope of the invention as defined by the appended claims.

## Claims

1. An ion source comprising:
a chamber (210);
a first hollow cathode body (212) having a first hollow cathode cavity (112) and a first plasma exit orifice (110B) and a second hollow cathode body (212) having a second hollow cathode cavity (112) and a second plasma exit orifice (110B), the first and second hollow cathode bodies (212) being disposed adjacently in the chamber;
a first ion accelerator (420) between and in communication with the first plasma exit orifice (110B) and the chamber (210), wherein the first ion accelerator (420) forms a first ion acceleration cavity (220); and
a second ion accelerator (420) between and in communication with the second plasma exit orifice (110B) and the chamber (210), wherein the second ion accelerator (420) forms a second ion acceleration cavity (220),
wherein the first hollow cathode body (212) and the second hollow cathode body (212) are configured to alternatively function as electrode and counter-electrode to generate a plasma, and
wherein each of the first hollow cathode and second hollow cathode bodies in combination with the respective first and second ion acceleration cavities are configured to generate the necessary repulsive force for enabling the extraction and acceleration of ions without the presence of magnetic fields,
wherein the first ion acceleration cavity (220) comprises an integral part of the first hollow cathode body (212) and/or the second ion acceleration cavity (220) comprises an integral part of the second hollow cathode body (212), and
**characterized in that** a width of the first ion acceleration cavity (220) is larger than a width of the first plasma exit orifice (110B), and a width of the second ion acceleration cavity (220) is larger than a width of the second plasma exit orifice (110B).

2. The ion source of claim 1, wherein the first ion acceleration cavity (220) comprises a slot in the first ion accelerator (420) and/or the second ion acceleration cavity (220) comprises a slot in the second ion accelerator (420).

3. The ion source of claim 1, wherein the first ion accelerator (420) and the first hollow cathode body (212) are electrically insulated from each other and/or the second ion accelerator (420) and the second hollow cathode body (212) are electrically insulated from each other.

4. The ion source of claim 1, wherein at least one of the first ion acceleration cavity (220) and the second ion acceleration cavity (220) is in the form of one of a counterbore, a rectangular slot, a semicircle, a cone, an inverted cone, and a bell shape.

5. The ion source of claim 1, wherein at least one of the first plasma exit orifice (110B) and the second plasma exit orifice (110B) comprises at least one plasma exit nozzle (110A).

6. The ion source of claim 1, wherein at least one of the first plasma exit orifice (110B) and the second plasma exit orifice (110B) comprises a linear slot.

7. The ion source of claim 1, further including a source of power configured to power at least one of the first hollow cathode body (212), the first ion accelerator (420), the second hollow cathode body (212), and the second ion accelerator (420).

8. The ion source of claim 1, wherein the ion source (200A) is from about 0.1m to about 4m long and has uniform plasma and ion emission over the length of the ion source.

9. A method of extracting and accelerating ions comprising:
(i) providing an ion source (200A) according to claim 1;
(ii) generating a plasma using the first hollow cathode body (212) and the second hollow cathode body (212), wherein the first hollow cathode body (212) and the second hollow cathode body (212) alternatively function as electrode and counter-electrode; and
(iii) extracting and accelerating ions; wherein each of the first hollow cathode and second hollow cathode bodies in combination with the respective first and second ion acceleration cavities generate the necessary repulsive force for enabling the extraction and acceleration of ions without the presence of magnetic fields.

10. The method of claim 9, wherein the extracted and accelerated ions from at least one of the first ion acceleration cavity (220) and the second ion acceleration cavity (220) form one of: a single narrow beam, a single large-area beam, an array of single beams, a continuous linear beam curtain, and a collimated ion beam.

11. The method of claim 9, wherein the first hollow cathode body (212) and the first ion accelerator (420) are at a first same electric potential difference and the second hollow cathode body (212) and the second ion accelerator (420) are at a second same electric potential difference.

12. The method of claim 9, wherein the first hollow cathode body (212) and the first ion accelerator (420) are at a first same polarity relative to an electric potential of the plasma and the second hollow cathode body (212) and the second ion accelerator (420) are at a second same polarity relative to the electric potential of the plasma.

13. The method of claim 9, wherein an average energy of the extracted and accelerated ions is less than 100eV.

14. The method of claim 9, wherein an average energy of the extracted and accelerated ions is greater than 100eV.

15. The method of claim 9, wherein the ion source (200A) further includes a source of power configured to power at least one of the first hollow cathode body (212), the first ion accelerator (420), the second hollow cathode body (212), and the second ion accelerator (420), and wherein the source of power operates at a root-mean-square AC voltage between 20V and 1000V.

## Patentansprüche

1. lonenquelle, die Folgendes umfasst:
eine Kammer (210);
einen ersten Hohlkathodenkörper (212), der einen ersten Hohlkathodenhohlraum (112) und eine erste Plasmaaustrittsöffnung (110B) aufweist, und einen zweiten Hohlkathodenkörper (212), der einen zweiten Hohlkathodenhohlraum (112) und eine zweite Plasmaaustrittsöffnung (110B) aufweist, wobei der erste und der zweite Hohlkathodenkörper (212) aneinandergrenzend in der Kammer angeordnet sind;
einen ersten lonenbeschleuniger (420) zwischen und in Kommunikation mit der ersten Plasmaaustrittsöffnung (110B) und der Kammer (210), wobei der erste lonenbeschleuniger (420) einen ersten lonenbeschleunigungshohlraum (220) bildet; und
einen zweiten lonenbeschleuniger (420) zwischen und in Kommunikation mit der zweiten Plasmaaustrittsöffnung (110B) und der Kammer (210), wobei der zweite lonenbeschleuniger (420) einen zweiten lonenbeschleunigungshohlraum (220) bildet,
wobei der erste Hohlkathodenkörper (212) und der zweite Hohlkathodenkörper (212) dazu konfiguriert sind, alternativ als Elektrode und Gegenelektrode zu fungieren, um ein Plasma zu generieren, und
wobei jeder des ersten Hohlkathoden- und des zweiten Hohlkathodenkörpers in Kombination mit dem jeweiligen ersten und zweiten lonenbeschleunigungshohlraum dazu konfiguriert sind, die erforderliche Repulsionskraft zu generieren, um die Extraktion und Beschleunigung von Ionen ohne die Gegenwart von Magnetfeldern zu ermöglichen,
wobei der erste lonenbeschleunigungshohlraum (220) einen integralen Teil des ersten Hohlkathodenkörpers (212) umfasst und/oder der zweite lonenbeschleunigungshohlraum (220) einen integralen Teil des zweiten Hohlkathodenkörpers (212) umfasst, und
**dadurch gekennzeichnet, dass** eine Breite des ersten lonenbeschleunigungshohlraums (220) größer ist als eine Breite der ersten Plasmaaustrittsöffnung (110B) und eine Breite des zweiten lonenbeschleunigungshohlraums (220) größer ist als eine Breite der zweiten Plasmaaustrittsöffnung (110B).

2. lonenquelle nach Anspruch 1, wobei der erste lonenbeschleunigungshohlraum (220) einen Schlitz in dem ersten lonenbeschleuniger (420) umfasst und/oder der zweite lonenbeschleunigungshohlraum (220) einen Schlitz in dem zweiten lonenbeschleuniger (420) umfasst.

3. lonenquelle nach Anspruch 1, wobei der erste lonenbeschleuniger (420) und der erste Hohlkathodenkörper (212) elektrisch voneinander isoliert sind und/oder der zweite lonenbeschleuniger (420) und der zweite Hohlkathodenkörper (212) elektrisch voneinander isoliert sind.

4. lonenquelle nach Anspruch 1, wobei mindestens einer des ersten lonenbeschleunigungshohlraums (220) und des zweiten lonenbeschleunigungshohlraums (220) die Form einer Gegenbohrung, eines rechteckigen Schlitzes, eines Halbkreises, eines Kegels, eines umgekehrten Kegels und einer Glockengestalt aufweist.

5. lonenquelle nach Anspruch 1, wobei mindestens eine der ersten Plasmaaustrittsöffnung (110B) und der zweiten Plasmaaustrittsöffnung (110B) mindestens eine Plasmaaustrittsdüse (110A) umfasst.

6. lonenquelle nach Anspruch 1, wobei mindestens eine der ersten Plasmaaustrittsöffnung (110B) und der zweiten Plasmaaustrittsöffnung (110B) einen linearen Schlitz umfasst.

7. lonenquelle nach Anspruch 1, die weiter eine Stromquelle beinhaltet, die dazu konfiguriert ist, mindestens einen des ersten Hohlkathodenkörpers (212), des ersten lonenbeschleunigers (420), des zweiten Hohlkathodenkörpers (212) und des zweiten lonenbeschleunigers (420) zu bestromen.

8. lonenquelle nach Anspruch 1, wobei die lonenquelle (200A) etwa 0,1 m bis etwa 4 m lang ist und eine gleichmäßige Plasma- und lonenemission über die Länge der lonenquelle aufweist.

9. Verfahren zum Extrahieren und Beschleunigen von Ionen, umfassend:
(i) Bereitstellen einer lonenquelle (200A) nach Anspruch 1;
(ii) Erzeugen eines Plasmas unter Verwenden des ersten Hohlkathodenkörpers (212) und des zweiten Hohlkathodenkörpers (212), wobei der erste Hohlkathodenkörper (212) und der zweite Hohlkathodenkörper (212) alternativ als Elektrode und Gegenelektrode fungieren; und
(iii) Extrahieren und Beschleunigen von Ionen; wobei jeder des ersten Hohlkathoden- und des zweiten Hohlkathodenkörpers in Kombination mit dem jeweiligen ersten und zweiten lonenbeschleunigungshohlraum die erforderliche Repulsionskraft generieren, um die Extraktion und Beschleunigung von Ionen ohne die Gegenwart von Magnetfeldern zu ermöglichen.

10. Verfahren nach Anspruch 9, wobei die extrahierten und beschleunigten Ionen aus mindestens einem des ersten lonenbeschleunigungshohlraums (220) und des zweiten lonenbeschleunigungshohlraums (220) eines bilden von: einem einzelnen schmalen Strahl, einem einzelnen großflächigen Strahl, einem Array einzelner Strahlen, einem kontinuierlichen linearen Strahlenvorhang und einem kollimierten lonenstrahl.

11. Verfahren nach Anspruch 9, wobei der erste Hohlkathodenkörper (212) und der erste lonenbeschleuniger (420) eine erste gleiche elektrische Potenzialdifferenz aufweisen, und der zweite Hohlkathodenkörper (212) und der zweite lonenbeschleuniger (420) eine zweite gleiche elektrische Potenzialdifferenz aufweisen.

12. Verfahren nach Anspruch 9, wobei der erste Hohlkathodenkörper (212) und der erste lonenbeschleuniger (420) eine erste gleiche Polarität in Bezug auf ein elektrisches Potenzial des Plasmas aufweisen, und der zweite Hohlkathodenkörper (212) und der zweite lonenbeschleuniger (420) eine zweite gleiche Polarität in Bezug auf das elektrische Potenzial des Plasmas aufweisen.

13. Verfahren nach Anspruch 9, wobei eine durchschnittliche Energie der extrahierten und beschleunigten Ionen kleiner ist als 100 eV.

14. Verfahren nach Anspruch 9, wobei eine durchschnittliche Energie der extrahierten und beschleunigten Ionen größer ist als 100 eV.

15. Verfahren nach Anspruch 9, wobei die lonenquelle (200A) weiter eine Stromquelle beinhaltet, die dazu konfiguriert ist, mindestens einen des ersten Hohlkathodenkörpers (212), des ersten lonenbeschleunigers (420), des zweiten Hohlkathodenkörpers (212) und des zweiten lonenbeschleunigers (420) zu bestromen, und wobei die Stromquelle mit einer Effektiv-Wechselspannung zwischen 20 V und 1000 V arbeitet.

## Revendications

1. Source d'ions comprenant :
une chambre (210) ;
un premier corps de cathode creuse (212) présentant une première cavité de cathode creuse (112) et un premier orifice de sortie de plasma (110B) et un second corps de cathode creuse (212) présentant une seconde cavité de cathode creuse (112) et un second orifice de sortie de plasma (110B), les premier et second corps de cathode creuse (212) étant disposés de manière adjacente dans la chambre ;
un premier accélérateur d'ions (420) entre le premier orifice de sortie de plasma (110B) et la chambre (210) et en communication avec ceux-ci, dans lequel le premier accélérateur d'ions (420) forme une première cavité d'accélération d'ions (220) ; et
un second accélérateur d'ions (420) entre le second orifice de sortie de plasma (110B) et la chambre (210) et en communication avec ceux-ci, dans lequel le second accélérateur d'ions (420) forme une seconde cavité d'accélération d'ions (220),
dans laquelle le premier corps de cathode creuse (212) et le second corps de cathode creuse (212) sont configurés pour fonctionner alternativement comme une électrode et une contre-électrode pour générer un plasma, et
dans laquelle chacun des premier et second corps de cathode creuse en combinaison avec les première et seconde cavités d'accélération d'ions respectives sont configurés pour générer la force répulsive nécessaire pour permettre l'extraction et l'accélération d'ions sans la présence de champs magnétiques,
dans laquelle la première cavité d'accélération d'ions (220) comprend une partie intégrante du premier corps de cathode creuse (212) et/ou la seconde cavité d'accélération d'ions (220) comprend une partie intégrante du second corps de cathode creuse (212), et
**caractérisée en ce qu'**une largeur de la première cavité d'accélération d'ions (220) est supérieure à une largeur du premier orifice de sortie de plasma (110B), et une largeur de la seconde cavité d'accélération d'ions (220) est supérieure à une largeur du second orifice de sortie de plasma (110B).

2. Source d'ions selon la revendication 1, dans laquelle la première cavité d'accélération d'ions (220) comprend une fente dans le premier accélérateur d'ions (420) et/ou la seconde cavité d'accélération d'ions (220) comprend une fente dans le second accélérateur d'ions (420).

3. Source d'ions selon la revendication 1, dans laquelle le premier accélérateur d'ions (420) et le premier corps de cathode creuse (212) sont électriquement isolés l'un de l'autre et/ou le second accélérateur d'ions (420) et le second corps de cathode creuse (212) sont électriquement isolés l'un de l'autre.

4. Source d'ions selon la revendication 1, dans laquelle au moins l'une parmi la première cavité d'accélération d'ions (220) et la seconde cavité d'accélération d'ions (220) est sous la forme de l'un parmi un lamage, une fente rectangulaire, un demi-cercle, un cône, un cône inversé et une forme de cloche.

5. Source d'ions selon la revendication 1, dans laquelle au moins l'un parmi le premier orifice de sortie de plasma (110B) et le second orifice de sortie de plasma (110B) comprend au moins une buse de sortie de plasma (110A).

6. Source d'ions selon la revendication 1, dans laquelle au moins l'un parmi le premier orifice de sortie de plasma (110B) et le second orifice de sortie de plasma (110B) comprend une fente linéaire.

7. Source d'ions selon la revendication 1, incluant en outre une source de puissance configurée pour alimenter au moins l'un parmi le premier corps de cathode creuse (212), le premier accélérateur d'ions (420), le second corps de cathode creuse (212) et le second accélérateur d'ions (420).

8. Source d'ions selon la revendication 1, dans laquelle la source d'ions (200A) fait d'environ 0,1 m à environ 4 m de long et présente une émission de plasma et d'ions uniforme sur la longueur de la source d'ions.

9. Procédé d'extraction et d'accélération d'ions comprenant les étapes consistant à :
(i) fournir une source d'ions (200A) selon la revendication 1 ;
(ii) générer un plasma en utilisant le premier corps de cathode creuse (212) et le second corps de cathode creuse (212), dans lequel le premier corps de cathode creuse (212) et le second corps de cathode creuse (212) fonctionnent alternativement comme une électrode et une contre-électrode ; et
(iii) extraire et accélérer des ions ; dans lequel chacun des premier et second corps de cathode creuse en combinaison avec les première et seconde cavités d'accélération d'ions respectives génèrent la force répulsive nécessaire pour permettre l'extraction et l'accélération d'ions sans la présence de champs magnétiques.

10. Procédé selon la revendication 9, dans lequel les ions extraits et accélérés depuis au moins l'une parmi la première cavité d'accélération d'ions (220) et la seconde cavité d'accélération d'ions (220) forment l'un parmi : un faisceau étroit unique, un faisceau à grande surface unique, un réseau de faisceaux uniques, un rideau de faisceau linéaire continu, et un faisceau d'ions collimaté.

11. Procédé selon la revendication 9, dans lequel le premier corps de cathode creuse (212) et le premier accélérateur d'ions (420) sont à une même première différence de potentiel électrique et le second corps de cathode creuse (212) et le second accélérateur d'ions (420) sont à une même seconde différence de potentiel électrique.

12. Procédé selon la revendication 9, dans lequel le premier corps de cathode creuse (212) et le premier accélérateur d'ions (420) sont à une même première polarité par rapport à un potentiel électrique du plasma et le second corps de cathode creuse (212) et le second accélérateur d'ions (420) sont à une même seconde polarité par rapport au potentiel électrique du plasma.

13. Procédé selon la revendication 9, dans lequel une énergie moyenne des ions extraits et accélérés est inférieure à 100 eV.

14. Procédé selon la revendication 9, dans lequel une énergie moyenne des ions extraits et accélérés est supérieure à 100 eV.

15. Procédé selon la revendication 9, dans lequel la source d'ions (200A) inclut en outre une source de puissance configurée pour alimenter au moins l'un parmi le premier corps de cathode creuse (212), le premier accélérateur d'ions (420), le second corps de cathode creuse (212), et le second accélérateur d'ions (420), et dans lequel la source de puissance fonctionne à une tension CA de valeur moyenne quadratique entre 20 V et 1 000 V.
